# EUROPÄISCHE PATENTANMELDUNG

(11) **EP 0 996 205 A1**
(43) Veröffentlichungstag der Anmeldung: **26.04.2000**
(21) Anmeldenummer: 99118080.3
(22) Anmeldetag: 24.09.1999
(51) Int. Cl.: H02B 1/01, A47B 96/06

(54) **Einhängbare Stützvorrichtung**

(30) Priorität: 18.10.1998 DE 29815509 U
(71) Anmelder: Muschik, Hans, 85649 Hofolding (DE)
(72) Erfinder: Muschik, Hans, 85649 Hofolding (DE)
(74) Vertreter: Neidl-Stippler & Partner

(57) **Zusammenfassung**

Die Erfindung betrifft eine einhängbare Stützvorrichtung zum lösbaren Befestigen an einem vertikal verlaufenden rechtwinkligen Stützprofil mit mindestens zwei Öffnungen in einer seiner Flächen, insbesondere einer vertikalen Einbauleiste eines Verteilerschrankes, mit einem Trageteil (18) mit einem im wesentlichen U-förmigen Hauptabschnitt, bei dem die beiden Schenkel des U einen oberen Stützabschnitt (20) und eine unteren Stützabschnitt (22) bilden und einem zum Hauptabschnitt im wesentlichen rechtwinkelig abgebogenen Einrastteilbefestigungsabschnitt (19) mit einem oberen Einrastteil (12) und einem unteren Einrastteil (12') zum Einrasten in Öffnungen; und mindestens einer am Hauptabschnitt des Trageteils angeordnete Feststelleinrichtung (16, 17) zum Vorspannen eines Andruckteils (15) der Feststelleinrichtung rechtwinkelig gegen Einrastteile (12, 12') an den oberen (20) und unteren Stützabschnitten (22).

## Beschreibung

Die Erfindung betrifft eine einhängbare Stützvorrichtung zum lösbaren Befestigen an einer vertikal verlaufenden rechtwinkligen Stützprofil mit mindestens zwei Öffnungen in einer der rechtwinkeligen Flächen, insbesondere einer vertikalen Einbauleiste eines Verteilerschrankes.

Allgemein besteht häufig die Notwendigkeit, an einer im wesentlichen senkrecht verlaufenden, Öffnungen aufweisenden Stützen, wie einem Winkeleisen mit einer Lochleiste, vorübergehend Abstützhilfen anzubringen. Ein typischer Fall tritt bei der Installation von Verteilerschränken oder anderen regalartigen Systemen, bei denen die Stützen aus Winkeleisen mit Lochleisten bestehen, an die dann regalartig sogenannte 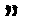 Patchfelder" od. dgl. angebaut oder installiert oder deinstalliert werden sollen, auf Es ist dabei erwünscht, temporär an der Stütze eine Abstützung oder Tragehilfe vorzusehen, die vorübergehend herausgezogene Teile am Verteilerschrank abstützen kann. Bisher war daher bspw. die Nachinstallation von Verteilerschränken, die ein Herausziehen von Patch-Panels oder anderen Einbauten im Schrank erforderte, problematisch, da herausgezogene Teile ohne Abstützung unnötigerweise vollständig ausgebaut werden mußten, um nachinstalliert zu werden oder aber eine Hilfsperson zum Halten des unabgestützten Teils notwendig war.

Es ist daher Aufgabe der Erfindung, eine einhängbare Stützvorrichtung zu schaffen, die eine einfache und schnelle Anbringung und Abstützung an einer Stütze ermöglicht, ohne daß Werkzeuge zum Anschrauben od. dlg. Notwendig sind. Diese Stützvorrichtung soll nach Beendigung der Arbeiten leicht und unproblematisch wieder zu entfernen sein.

Die Aufgabe wird erfindungsgemäß gelöst durch eine einhängbare Stützvorrichtung zum lösbaren Befestigen an einem vertikal verlaufenden rechtwinkligen Stützprofil mit mindestens zwei Öffnungen in einer der rechtwinkeligen Flächen, insbesondere einer vertikalen Einbauleiste eines Verteilerschrankes, die aufweist:
ein Trageteil (18) mit einem im wesentlichen U-förmigen Hauptabschnitt, bei dem die beiden Schenkel des U einen oberen Stützabschnitt (20) und eine unteren Stützabschnitt (22) bilden und einem zum Hauptabschnitt im wesentlichen rechtwinkelig abgebogenen Einrastteilbefestigungsabschnitt (19) mit einem oberen Einrastteil (12) und einem unteren Einrastteil (12') zum Einrasten in Öffnungen; und
mindestens eine am Hauptabschnitt des Trageteils angeordnete Feststelleinrichtung (16, 17) zum Vorspannen eines Andruckteils (15) der Feststelleinrichtung rechtwinkelig gegen Einrastteile (12, 12') an den oberen (20) und unteren Stützabschnitten (22).

Dabei wird ein Abschnitt einer Winkelprofil-Stütze mit einer Lochreihe zwischen den Einrastteilen, die in den Löchern einrasten, und dem Andruckteil, das ein druckausübendes Element auf den dem Lochprofil gegenüberliegenden Schenkel des Winkelprofils drückt, eingespannt, wodurch die Stützvorrichtung sicher an der vertikalen Stütze angeklemmt wird und auf ihrem Stützabschnitt Teile abgelegt werden können.

Es ist ein Vorteil der Erfindung, daß die Stützeinrichtung zur Anbringung bei Servicearbeiten bspw. bei Einschüben von Verteilerschränken od. dgl. keine Schrauben od. dgl. benötigt. Stattdessen kann sie einfach rückseitig an vertikal verlaufenden Einbauwinkelprofilleisten angebracht werden. Die Aufnahme der Stützvorrichtung erfolgt über Exzenter und/oder Bolzen und/oder Schnellbefestigung und/oder Einsteckklammern in vertikale Schienen handelsüblicher Datenschränke, Verteilerschränke od. dgl. in 19-Zoll oder metrischer Ausführung.

Die Neigung der Stützvorrichtung kann ggf. durch Positionierbolzen verstellbar gestaltet sein.

Es kann sinnvoll sein, daß die Einrastteile hakenartige Fortsätze, die sich vom Einrastteilbefestigungsabschnitt 19 aus in dessen Haupterstreckungsrichtung erstrecken, sind. In diesem Fall wird der Einrastteilbefestigungsabschnitt an seiner Endkante durch hakenartige Fortsätze verlängert, die bspw. einfach an einem Materialabschnitt angeschnitten sind, so daß für die Herstellung der hakenartigen Fortsätze keine zusätzlichen Arbeitsschritte notwendig sind und auch das Auftreten möglicher Schwachstellen an Schweißpunkten oder anderen Befestigungspunkten vermieden werden kann.

Es kann aber auch vorgesehen sein, daß die Einrastteile Fortsätze, bspw. Stifte, die sich vom Einrastteilbefestigungsabschnitt 19 nach innen erstrecken, sind. Diese Stifte werden dann in Löcher in dem Lochprofil der Stütze eingesetzt und durch ein druckausübendes Element wird Druck auf den anderen Schenkel des Winkelprofils zwischen den Einrastteilen ausgeübt, so daß sich die Stützvorrichtung derart am Winkelprofil festklemmt.

Als Feststelleinrichtung kann bspw. ein Federstift vorgesehen sein. Dies hat den Vorteil, daß es eine einfach manuell zu handhabende Druckeinrichtung ist, die ohne Werkzeuge gelöst und gespannt werden kann. Dabei wird der auszuübende Druck durch die Federkraft des Federstiftes bestimmt.

Es ist aber auch möglich, daß die Feststelleinrichtung ein Exzenter ist, der von Hand gespannt wird und es so ermöglicht, eine größere Kraft, die inelastisch Druck ausübt, auf das druckausübende Element aufzubringen.

Das Trageteil mit seinen oberen und unteren Stützabschnitten und dem Einrastteilbefestigungsabschnitt ist bevorzugt aus einem einzigen gebogenen Materialzuschnitt hergestellt - dadurch können aufwendige Herstellungsvorgänge vermieden werden.

Es ist von der Herstellung her besonders günstig, wenn das Trageteil auch einstückig mit den Einrastteilen - bspw. am Einrastteilbefestigungsabschnitt angeschnittene Haken oder andere Fortsätze zum Einsetzen in die Löcher einer Stütze, ist.

Vorteilhafterweise besitzt das Trageteil Einrichtungen, um an ihm Gegenstände befestigen zu können, wie Durchbrüche, Öffnungen, Schlitze od. dgl.., die unproblematisch gleichzeitig mit dem Materialzuschnitt für das Trageteil ausgestanzt oder geschnitten werden können, ohne zusätzliche Bearbeitungsschritte zu benötigen

Es ist besonders vorteilhaft, daß das Trageteil aus einem Blechzuschnitt gebogen ist. Da so eine widerstandsfähige Konstruktion entsteht.

In einigen Fällen ist es aber auch erwünscht, daß das Trageteil zumindest teilweise aus einem elektrisch isolierenden Material hergestellt ist - dafür bieten sich dann entweder beschichtete Metallteile oder aber direkt Kunststoffe an.

Es kann günstig sein, daß die Feststelleinrichtung ein Federstift (16) ist, der beim Loslassen den Stift gegen die Stütze drückt und somit die Stütz6vorrichtung an einem Stützenabschnitt zwischen dem federbelasteten Stift und den Haken festklemmt .

Es kann auch bspw. als Feststelleinrichtung ein Exzenter (17) vorgesehen sein, der von Hand zu spannen ist und derart die Stützeinrichtung lösbar befestigt.
Bevorzugt ist der Trageteil, die Einrastteile, der obere und der untere Stützabschnitt aus einem einzigen gebogenen Blechabschnitt hergestellt - dadurch ist eine einfache und problemlose Herstellung möglich und Schwachstellen durch Schweißnähte od. dgl. Vermieden werden können.
Bevorzugt weist die einhängbare Stützvorrichtung auch noch Befestigungseinrichtungen wie Durchbrüche, Öffnungen, Schlitze od. Dgl. Aufweist

Durch die erfindungsgemäße Stützvorrichtung ist eine problemlose Unterstützung des Einbaus von Einschüben bei rückseitiger Anbringung an vertikal verlaufender Einbauleiste mögliche. Bei vorderseitiger Anbringung am Trägersystem eines Verteilerschranks kann sie bspw. als Trägersystem bei Service arbeiten an Einschüben bzw. als Aufnahme für ein Servicebrett dienen.

Vorteilhafterweise benötigt die erfindungsgemäße Vorrichtung keine Schrauben und dgl. und kann bevorzugt durch Positionierbolzen verstellbar sein.

Nachfolgend wird die Erfindung detaillierter anhand von Ausführungsbeispielen, auf die sie keineswegs beschränkt ist, sowie der begleitenden Zeichnung näher erläutert. Dabei zeigt:
Fig. 1. Eine perspektivische Ansicht einer Ausführungsform der Erfindung;
Fig. 2 eine weitere perspektivische Ansicht der Ausführungsform der Fig. 1;
Fig. 3 eine perspektivische Ansicht einer weiteren Ausführungsform der Erfindung; und
Fig. 4 eine weitere perspektivische Ansicht der Ausführungsform der Fig. 3.

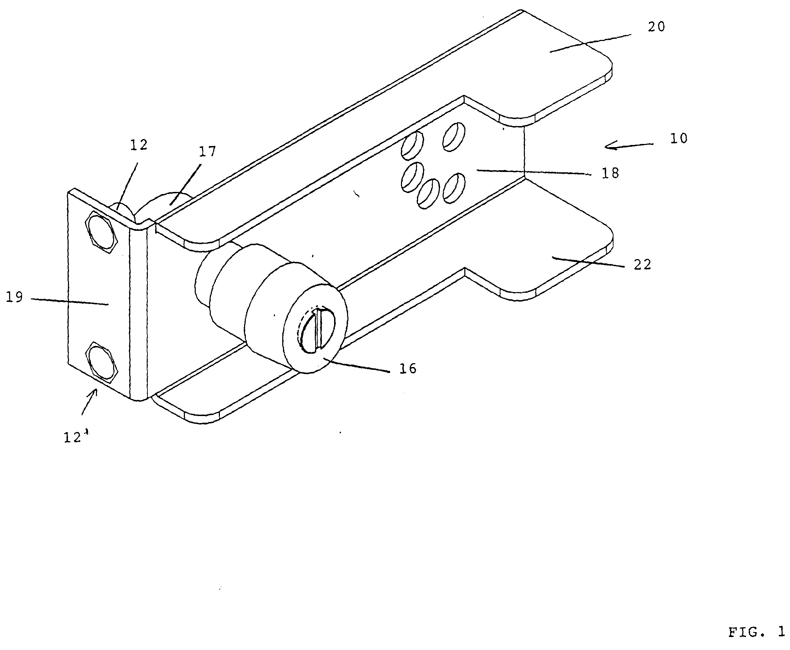

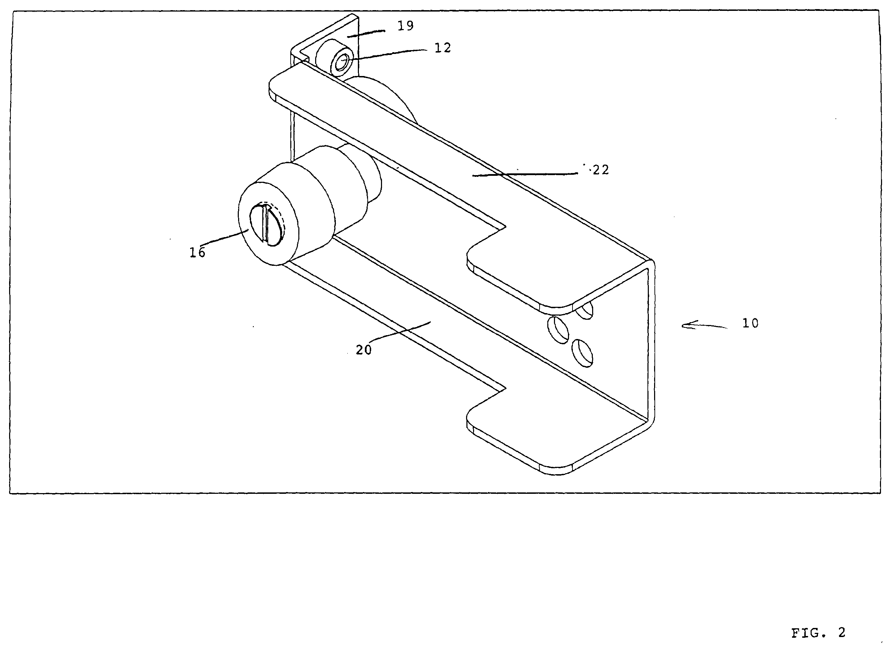

Wie in Fig. 1 dargestellt, ist ein einzelner Blechzuschnitt zu einem Trageteil 18 mit rechtwinklig auf die gleiche Seite abgebogenen Stützabschnitten 20, 22 gebogen, wobei ein Fortsatz des Trageteils 18 als Einrastteilbefestigungsabschnitt 19 entgegengesetzt der Stützabschnitte 20, 22 rechtwinkelig abgebogen. An diesem Einrastteilbefestigungsabschnitt 19 befinden sich Einrastteile - bei dieser Ausführungsform handelt es sich dabei um zwei stiftartige Fortsätze, die in Richtung des Trageteilhauptabschnittes verlaufen. Diese stiftartigen Fortsätze 12, 12' können in Löcher eines eine Lochreihe aufweisenden Winkelstützprofils eingesetzt werden und derart das die Stützvorrichtung an der Stütze anbringen. Durch den Hauptabschnitt des Trageteils verläuft hier ein Federstift 16, dessen druckausübendes Element 15 parallel zum Einrastteilbefestigungsabschnitt Druck ausübt und so nach Einrasten der stiftartigen Fortsätze in einem Winkelprofil durch Druck auf das andere Winkelteil des Winkelprofils die Stützvorrichtung am Winkelprofil festklemmt. Dabei erfolgt die Klemmkraft durch die Feder des Federstiftes, ist also durch deren Federkraft begrenzt. Durch die symmetrische Anbringung der Stützabschnitte am Trageteil 18 kann die Stützvorrichtung sowohl an Winkelprofilen mit verschieden angebrachten Lochreihen beidseitig eingesetzt werden - wie in Fig. 2 dargestellt ist.

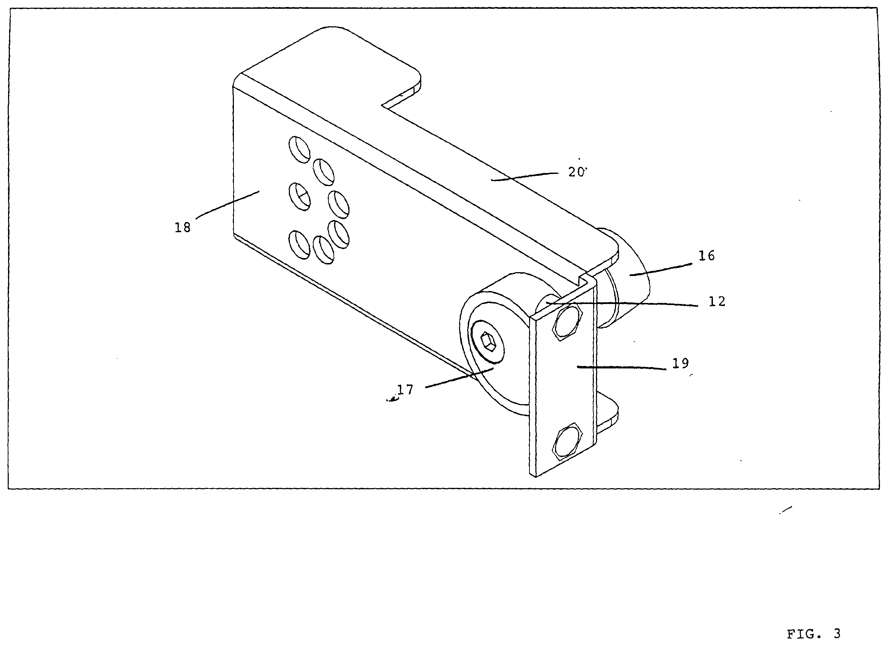

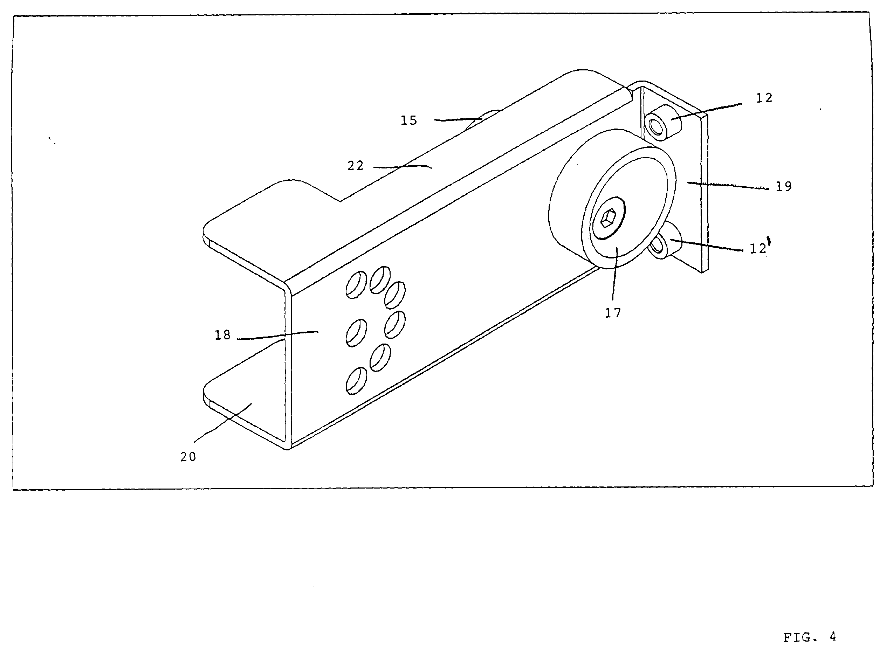

In Fig. 3 ist eine weitere Ausführungsform der Stützvorrichtung dargestellt, wobei hier ein Exzenter 17, der von Hand festzieh- und auch lösbar ist, vorgesehen ist. Dadurch, daß der Exzenter von Hand festgestellt werden kann, kann die Klemmkraft der Stützvorrichtung genau gesteuert werden und ein Nachfedern der Stützvorrichtung aufgrund einer Federkraft ist nicht mehr möglich. Somit ermöglicht die Ausführungsform mit Exzenter eine festere und nicht federnde Anbringung der Stützvorrichtung. Im übrigen ist das Ausführungsbeispiel der Fig. 3 und 4 identisch der Ausführungsform der Fig. 1 und 2.

Weitere Ausgestaltungen und Fortentwicklungen sind im Rahmen des Schutzumfangs der Ansprüche dem Fachmann offensichtlich und der Schutzumfang ist keineswegs auf die hier beispielhaft aufgeführten Ausführungsformen begrenzt, die lediglich zur Erläuterung dienen sollen.

### Bezugszeichenliste

- 10: Stützvorrichtung
- 12: oberes Einrastteil an 19
- 12': unteres Einrastteil an 19
- 15: druckausübendes Element von 16 oder 17
- 16: Federstift
- 17: Exzenter
- 18: Trageteil
- 19: Einrastteilbefestigungsabschnitt von 18
- 20: oberer Stützabschnitt von 18
- 22: unterer Stützabschnitt von 18

## Patentansprüche

1. Einhängbare Stützvorrichtung zum lösbaren Befestigen an einem vertikal verlaufenden rechtwinkligen Stützprofil mit mindestens zwei Öffnungen in einer seiner Flächen, insbesondere einer vertikalen Einbauleiste eines Verteilerschrankes, gekennzeichnet durch:
ein Trageteil (18) mit einem im wesentlichen U-förmigen Hauptabschnitt, bei dem die beiden Schenkel des U einen oberen Stützabschnitt (20) und eine unteren Stützabschnitt (22) bilden und einem zum Hauptabschnitt im wesentlichen rechtwinkelig abgebogenen Einrastteilbefestigungsabschnitt (19) mit einem oberen Einrastteil (12) und einem unteren Einrastteil (12') zum Einrasten in Öffnungen; und
mindestens eine am Hauptabschnitt des Trageteils angeordnete Feststelleinrichtung (16, 17) zum Vorspannen eines Andruckteils (15) der Feststelleinrichtung rechtwinkelig gegen Einrastteile (12, 12') an den oberen (20) und unteren Stützabschnitten (22).

2. Einhängbare Stützvorrichtung nach Anspruch 1 oder 2, dadurch gekennzeichnet, daß die Einrastteile hakenartige Fortsätze, die sich vom Einrastteilbefestigungsabschnitt 19 aus in dessen Haupterstreckungsrichtung erstrecken, sind.

3. Einhängbare Stützvorrichtung nach Anspruch 1 oder 2, dadurch gekennzeichnet, daß die Einrastteile Fortsätze, bspw. Stifte, die sich vom Einrastteilbefestigungsabschnitt 19 nach innen erstrecken, sind.

4. Einhängbare Stützvorrichtung nach einem der vorangehenden Ansprüche, dadurch gekennzeichnet, daß die Feststelleinrichtung ein Federstift (16) ist.

5. Einhängbare Stützvorrichtung nach einem der vorangehenden Ansprüche 1 bis 3, dadurch gekennzeichnet, daß die Feststelleinrichtung ein Exzenter (17) ist.

6. Einhängbare Stützvorrichtung nach einem der Ansprüche 1 bis 5, dadurch gekennzeichnet, daß das Trageteil, mit, den oberen und unteren Stützabschnitten und dem Einrastteilbefestigungsabschnitt 19 aus einem gebogenen Materialzuschnitt hergestellt sind.

7. Einhängbare Stützvorrichtung nach Anspruch 6, dadurch gekennzeichnet, daß das Trageteil ferner einstückig mit den Einrastteilen ist.

8. Einhängbare Stützvorrichtung nach einem der vorangehenden Ansprüche, dadurch gekennzeichnet, daß das Trageteil Durchbrüche, Öffnungen, Schlitze od. dgl. aufweist.

9. Einhängbare Stützvorrichtung nach irgendeinem der vorangehenden Ansprüche, dadurch gekennzeichnet, daß das Trageteil aus einem Blechzuschnitt gebogen ist.

10. Einhängbare Stützvorrichtung nach irgendeinem der vorangehenden Ansprüche, dadurch gekennzeichnet, daß das Trageteil aus einem elektrisch isolierenden Material hergestellt ist.
